# EUROPEAN PATENT APPLICATION

(11) **EP 3 715 869 A1**
(43) Date of publication of application: **30.09.2020**
(21) Application number: 17933112.9
(22) Date of filing: 24.11.2017
(51) Int. Cl.: G01R 15/18, G01R 19/00, H01F 5/00

(54) **SEMICONDUCTOR DEVICE, SEMICONDUCTOR COMPONENT, AND METHOD FOR PRODUCING SEMICONDUCTOR DEVICE**

(71) Applicant: Shindengen Electric Manufacturing Co., Ltd., Tokyo 100-0004 (JP)
(72) Inventor: SASHIDA Kazuyuki, Hanno-shi Saitama 357-8585 (JP); YAMAJI Mizue, Hanno-shi Saitama 357-8585 (JP); YOSHIDA Kenichi, Hanno-shi Saitama 357-8585 (JP); SUZUKI Kenichi, Hanno-shi Saitama 357-8585 (JP); KUNORI Shinji, Hanno-shi Saitama 357-8585 (JP)
(74) Representative: AWA Sweden AB
(86) International application number: PCT/JP2017/042131
(87) International publication number: WO 2019/102570

(57) **Abstract**

A semiconductor device 100 has a first electrode 61; a second electrode 62; and a semiconductor layer 1 including a first winding wire part 10 provided so as to surround a current flowing between the first electrode 61 and the second electrode 62, and a second winding wire part 50 connected to a terminal end part of the first winding wire part 10 and returning from the terminal end part toward a starting end part side of the first winding wire part 10.

## Description

### Technical Field

The present invention relates to a semiconductor device and a semiconductor component having a winding wire part in a semiconductor layer, and a method for manufacturing the semiconductor device.

### Background Art

Conventionally, a current detection sensor using a Rogowski coil has been known. The Rogowski coil is a coreless coil, and has a winding core, a winding wire wound around the winding core, and a return wire connected to the terminal end part of the winding wire and returning to a starting end part side (for example, see JP 2012-88224 A). In addition, the Rogowski coil is connected to an integrator, and a change in current in an object to be measured can be measured by integrating the output voltage with the integrator. In such a Rogowski coil, the sensitivity is increased with an increase in the number of turns per unit distance.

Meanwhile, a sensor has been proposed which detects a change in current flowing through a semiconductor device (for example, a switching element). However, conventional sensors cannot detect a change in current flowing through the semiconductor device with sufficient accuracy, and there is a problem that the size of the entire device including the sensor may be increased.

### Summary of Invention

### Problem to be solved by invention

The present invention provides a semiconductor device, a combination, and a method of manufacturing a semiconductor device capable of accurately detecting an operation without an excessive increase in size.

### Means to Solve the Problem

A semiconductor device may comprise:
a first electrode;
a second electrode; and
a semiconductor layer including a first winding wire part provided so as to surround a current flowing between the first electrode and the second electrode, and a second winding wire part connected to a terminal end part of the first winding wire part and returning from the terminal end part toward a starting end part side of the first winding wire part.

In the semiconductor device according to the present invention,
the second winding wire part may be disposed outward of a periphery of the first winding wire part, or the first winding wire part may be disposed outward of a periphery of the second winding wire part.

In the semiconductor device according to the present invention,
the first winding wire part and the second winding wire part may be disposed in a nested shape.

In the semiconductor device according to the present invention,
thickness of the first winding wire part and thickness of the second winding wire part may be substantially a same value.

A semiconductor component may comprise a semiconductor layer, wherein
the semiconductor layer may include
a first winding wire part, and
a second winding wire part connected to a terminal end part of the first winding wire part and returning from the terminal end part toward a starting end part side of the first winding wire part, and
the semiconductor component may be disposed so as to surround a current flowing in an object to be measured.

A method of manufacturing a semiconductor device, according to the present invention, may comprise steps of:
forming a first insulating film partially on a semiconductor layer;
forming a trench using the first insulating film;
forming a second insulating film on an inner side wall and an inner bottom surface of the trench;
providing a conductive material in the trench where the second insulating film is formed and on the first insulating film;
forming a first winding wire part and a second winding wire part by patterning the conductive material; and
covering the winding wire part and the winding return wire part with a third insulating film, wherein
the second winding wire part may be connected to a terminal end part of the first winding wire part, and returns from the terminal end part toward a starting end part side of the first winding wire part.

### Effects of Invention

In one aspect of the present invention, the winding wire part is provided in the semiconductor layer. Thus, the configuration of the winding wire part can be miniaturized by utilizing the technique for manufacturing the semiconductor device, and the number of turns per unit length can be increased. Therefore, a change in current can be detected accurately. Further, since miniaturization is enabled as described above, an increase in size of the semiconductor device can be prevented, even if the winding wire part and the winding return wire part are provided in the semiconductor layer. Further, the second winding wire part is used as a winding return wire instead of a straight winding return wire such as a general Rogowski coil. By employing such a second winding wire part, it is possible to prevent the manufacturing process from becoming too complicated.

### Brief Description of Drawings

Fig. 1 is a plan view of a semiconductor device that can be used in a first embodiment of the present invention.
Fig. 2(a) is a longitudinal sectional view of a semiconductor device that can be used in the first embodiment of the present invention, and Fig. 2(b) is a longitudinal sectional view of another semiconductor device that can be used in the first embodiment of the present invention.
Fig. 3(a) is a longitudinal sectional view of a first winding wire part of the semiconductor device that can be used in the first embodiment of the present invention, Fig. 3(b) is a plan view of the semiconductor device shown in Fig. 3(a), and Fig. 3(c) is a longitudinal sectional view of a second winding wire part cut along a cross section different from that of Fig. 3(a).
Fig. 4(a) is a longitudinal sectional view for explaining a manufacturing process of the semiconductor device that can be used in the first embodiment of the present invention, and Fig. 4(b) is a plan view of the semiconductor device shown by Fig. 4(a).
Fig. 5(a) is a longitudinal sectional view for explaining a manufacturing process which has advanced from Fig. 4(a), and Fig. 5(b) is a plan view of the semiconductor device shown in Fig. 5(a).
Fig. 6(a) is a longitudinal sectional view for explaining a manufacturing process that has advanced from Fig. 5(a), and Fig. 6(b) is a plan view of the semiconductor device shown in Fig. 6(a).
Fig. 7(a) is a longitudinal sectional view for explaining a manufacturing process that has advanced from Fig. 6(a), and Fig. 7(b) is a plan view of the semiconductor device shown in Fig. 7(a).
Fig. 8(a) is a longitudinal sectional view for explaining a manufacturing process which has advanced from Fig. 7(a), and Fig. 8(b) is a plan view of the semiconductor device shown in Fig. 8(a).
Fig. 9 is a diagram showing a relationship between a semiconductor device and an integration circuit that can be used in the first embodiment of the present invention.
Fig. 10 is a longitudinal sectional view of a semiconductor device that can be used in a second embodiment of the present invention.
Fig. 11 is a plan view of the semiconductor device that can be used in the second embodiment of the present invention.
Fig. 12 is a plan view of a semiconductor device that can be used in a third embodiment of the present invention.
Fig. 13 is a longitudinal sectional view of a semiconductor device that can be used in a fourth embodiment of the present invention.
Fig. 14 is a longitudinal sectional view of another semiconductor device that can be used in the fourth embodiment of the present invention.
Fig. 15 is a longitudinal sectional view of still another semiconductor device that can be used in the fourth embodiment of the present invention.
Fig. 16(a) is a longitudinal sectional view of a semiconductor component and a semiconductor device that can be used in a fifth embodiment of the present invention, and Fig. 16(b) is a longitudinal sectional view of a semiconductor component and a semiconductor device according to another aspect that can be used in the fifth embodiment of the present invention.

### Description of Embodiments

### First Embodiment

### <<Configuration>>

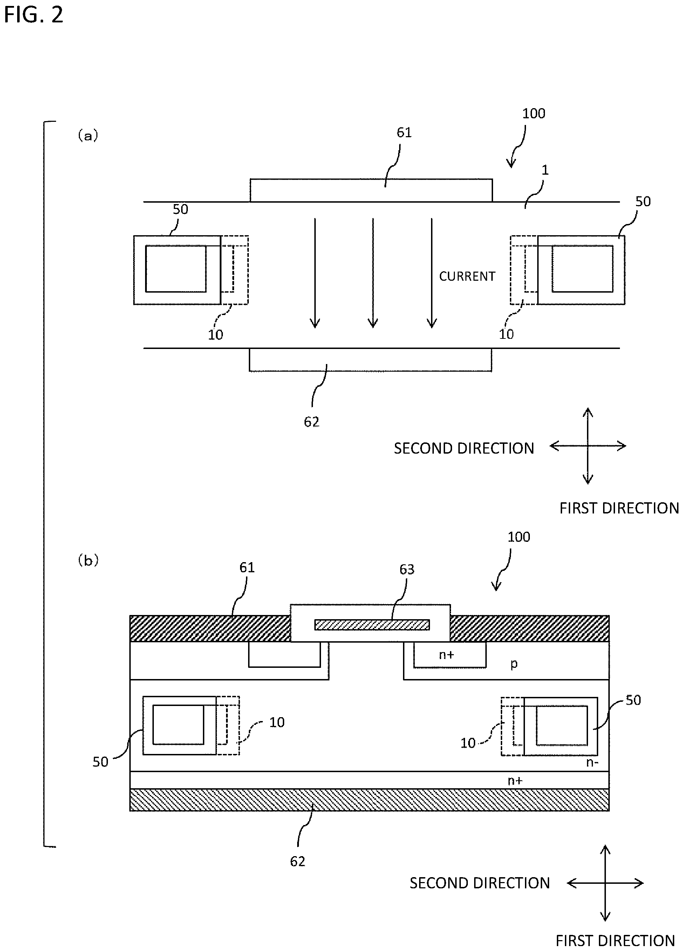

In the present embodiment, "one side" means the upper side in Fig. 2 and "other side" means the lower side in Fig. 2. Further, the vertical direction in Fig. 2 (the direction from the other side toward one side and the direction from one side toward the other side) is referred to as a "first direction", the horizontal direction in Fig. 2 is referred to as a "second direction", and the front-back direction of the page of Fig. 2 is referred to as a "third direction". An in-plane direction including the second direction and the third direction is referred to as a "plane direction", and a state where the view from the upper side in Fig 2 is referred to as a "plan view".

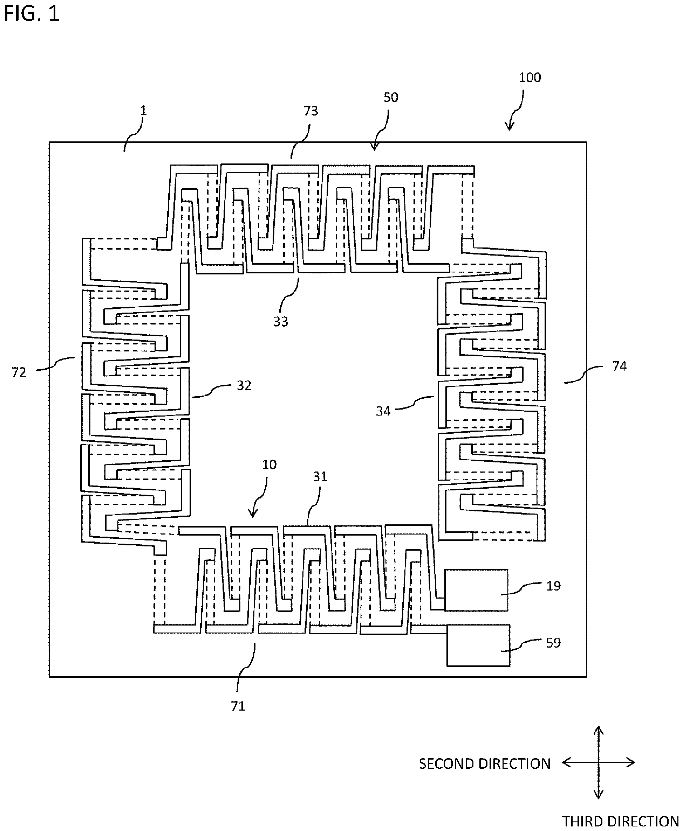

As shown in Fig. 2(a) the semiconductor device 100 of the present embodiment may have a first electrode 61, a second electrode 62, and a semiconductor layer 1 (see also Fig. 1) including a first winding wire part 10 provided so as to surround a current flowing between the first electrode 61 and the second electrode 62, and a second winding wire part 50 connected to the terminal end part of the first winding wire part 10 and returning from the terminal end part toward the starting end part side of the first winding wire part 10. As a semiconductor material, a material such as silicon, silicon carbide, or gallium nitride can be used. The aspect shown in Fig. 2(a) indicates an aspect in which the current flows from the upper side to the lower side. However, this is merely an example, and the current may flow from the lower side to the upper side.

Although the first winding wire part 10 and the second winding wire part 50 may be made of a semiconductor material such as polysilicon, the present invention is not limited to this, but they may be made of metal materials such as copper and aluminum, and the metal film may be the first winding wire part 10 and the second winding wire part 50. In the present embodiment, the first winding wire part 10 is disposed inward of a periphery of the second winding wire part 50.

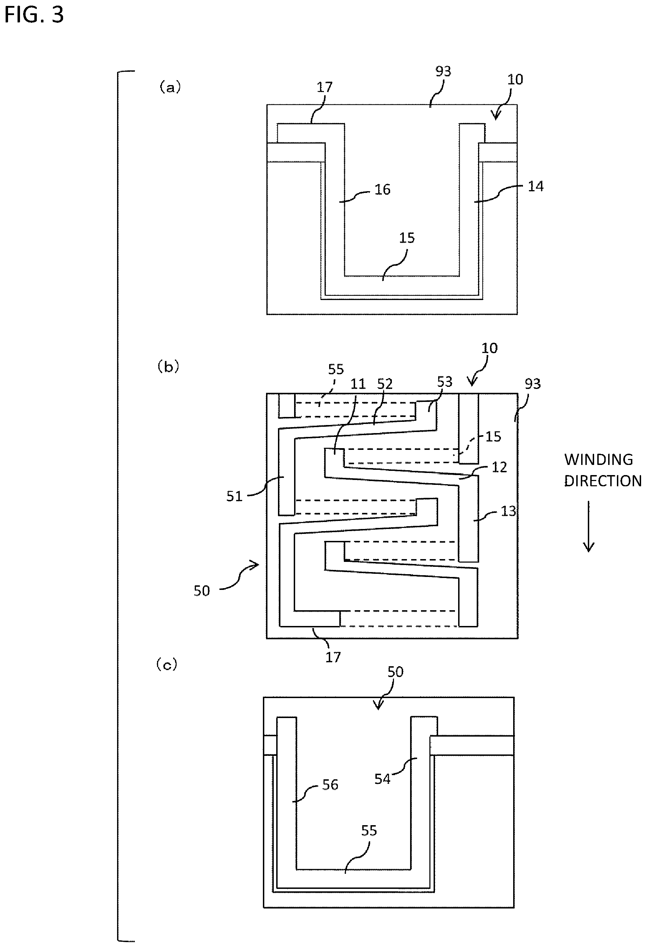

As shown in Fig. 3, the first winding wire part 10 may have a first straight part 11 extending in the winding direction, a second straight part 12 extending toward the peripherally inward (right side in Fig. 3) from the end of the first straight part 11 and extending in the plane direction (a direction including the second direction and the third direction) toward the winding direction, a third straight part 13 extending in the winding direction from the end of the second straight part 12, a fourth straight part 14 extending from one side toward the other side from the end of the third straight part 13, a fifth straight part 15 extending toward the peripherally outward (left side in Fig. 3) from the end of the fourth straight part 14 and extending in the plane direction toward the direction perpendicular to the winding direction, a sixth straight part 16 extending from the other side toward one side from the end of the fifth straight part 15 (first aspect). Further, a seventh straight part 17 extending in the plane direction toward the peripherally outward from the end of the sixth straight part 16 may be provided at the terminal end part of the first winding wire part 10, and the end of the seventh straight part 17 and the starting end part of the second winding wire part 50 may be connected.

The second winding wire part 50 may also have the same configuration as the first winding wire part 10. The second winding wire part 50 may have a first straight part 51 extending in the direction opposite to the winding direction, a second straight part 52 extending toward the peripherally inward (right side in Fig. 3) from the end of the first straight part 51 and extending in the plane direction (a direction including the second direction and the third direction) toward the direction opposite to the winding direction, a third straight part 53 extending from the end of the second straight part 52 in the direction opposite to the winding direction, a fourth straight part 54 extending from one side toward the other side from the end of the third straight part 53, a fifth straight part 55 extending toward the peripherally outward (left side in Fig. 3) from the end of the fourth straight part 54 and extending in the plane direction toward the direction perpendicular to the winding direction, and a sixth straight part 56 extending from the other side toward one side from the end of the fifth straight part 55 (first aspect).

Unlike this aspect, the first winding wire part 10 may have the first straight part 11 extending in the winding direction, the second straight part 12 extending toward the peripherally inward from the end of the first straight part 11 and extending in the plane direction (a direction including the second direction and the third direction) toward the winding direction, the third straight part 13 extending in the winding direction from the end of the second straight part 12, the fourth straight part 14 extending from the other side toward one side from the end of the third straight part 13, the fifth straight part 15 extending toward the peripherally outward from the end of the fourth straight part 14 and extending in the plane direction toward the direction perpendicular to the winding direction, and the sixth straight part 16 extending from one side toward the other side from the end of the fifth straight part 15 (second aspect).

In addition, the second winding wire part 50 may have the first straight part 51 extending in the direction opposite to the winding direction, the second straight part 52 extending toward the peripherally inward from the end of the first straight part 51 and extending in the plane direction (a direction including the second direction and the third direction) toward the direction opposite to the winding direction, the third straight part 53 extending from the end of the second straight part 52 in the direction opposite to the winding direction, the fourth straight part 54 extending from the other side toward one side from the end of the third straight part 53, the fifth straight part 55 extending toward the peripherally outward from the end of the fourth straight part 54 and extending in the plane direction toward the direction perpendicular to the winding direction, and the sixth straight part 56 extending from one side toward the other side from the end of the fifth straight part 55 (second aspect).

The first electrode 61 may be provided on a first main surface, and the second electrode 62 may be provided on a second main surface. In Fig. 2, the upper surface is defined as the first main surface, and the lower surface is defined as the second main surface. The semiconductor device 100 may be a switching element, and may be, for example, a vertical MOSFET. When the aspect of the present embodiment is adopted for the vertical MOSFET as shown in Fig. 2(b), the first electrode 61 may be a source electrode and the second electrode 62 may be a drain electrode. A quasi Rogowski coil like the present embodiment may be provided so as to surround the current flowing between the source electrode and the drain electrode. Note that reference numeral 63 in Fig. 2(b) denotes a gate electrode.

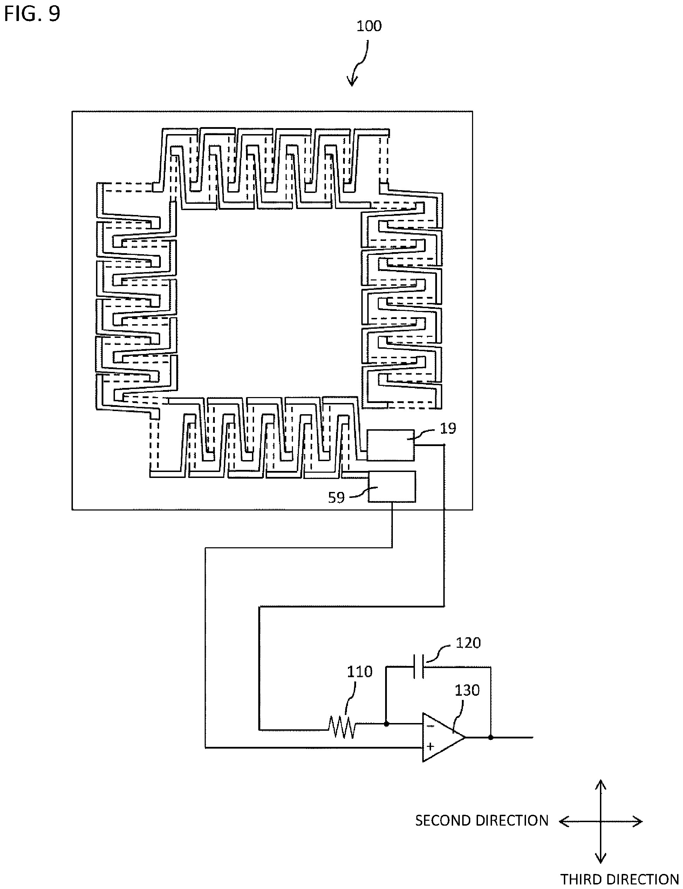

As shown in Fig. 9, the first winding wire part 10 and the second winding wire part 50 of the semiconductor layer 1 of the present embodiment may have an integration circuit by being connected to a resistor unit 110, a capacitor 120, and an operational amplifier 130 provided outside the semiconductor device 100. The invention is not limited to such an aspect, but the resistor unit 110, the capacitor 120, or the resistor unit 110 and the capacitor 120 of the integration circuit may be formed in the semiconductor layer 1. As an example, in Fig. 9, the winding wire electrode pad 19 connected to the starting end part of the first winding wire part 10 is connected to the resistor unit 110, the resistor unit 110 is connected to the capacitor 120 and the inverting input terminal of the operational amplifier 130, and the winding return wire electrode pad 59 connected to the terminal end part of the second winding wire part 50 is connected to the non-inverting input terminal of the operational amplifier 130.

As shown in Fig. 1, the first winding wire part 10 may have an A-direction first winding wire part 31 extending in the second direction, a B-direction first winding wire part 32 connected to the end of the A-direction first winding wire part 31 and extending in the third direction, a C-direction first winding wire part 33 connected to the end of the B-direction first winding wire part 32 and extending in the second direction, and a D-direction first winding wire part 34 connected to the end of the C-direction first winding wire part 33 and extending in the third direction. When such an aspect is used, each first direction winding wire part 31 to 34 can be formed in a straight shape, which is advantageous in that it can be manufactured relatively easily. Although the present embodiment will be described using four first direction winding wire parts 31 to 34, the present invention is not limited to this. A triangular shape may be formed in the plane direction by the three direction first winding wire parts, and a polygonal shape may be formed in the plane direction by the five or more direction first winding wire parts.

Similarly, the second winding wire part 50 may have an A-direction second winding wire part 71 extending in the second direction, a B-direction second winding wire part 72 connected to the end of the A-direction second winding wire part 71 and extending in the third direction, a C-direction second winding wire part 73 connected to the end of the B-direction second winding wire part 72 and extending in the second direction, and a D-direction second winding wire part 74 connected to the end of the C-direction second winding wire part 73 and extending in the third direction. When such an aspect is used, each of the second straight winding wire parts 71 to 74 can be formed in a straight shape, which is advantageous in that it can be manufactured relatively easily. Although the present embodiment will be described using the four second straight winding wire parts 71 to 74, the present invention is not limited to this. A triangular shape may be formed in the plane direction by the three direction second winding wire parts, and a polygonal shape may be formed in the plane direction by the five or more direction second winding wire parts.

Further, the lengths of the A-direction first winding wire part 31, the B-direction first winding wire part 32, the C-direction first winding wire part 33, and the D-direction first winding wire part 34 may correspond. The corresponding length means that each length of the A-direction first winding wire part 31, the B-direction first winding wire part 32, the C-direction first winding wire part 33, and the D-direction first winding wire part 34 is within ± 5% of the average value of the lengths of the A-direction first winding wire part 31, the B-direction first winding wire part 32, the C-direction first winding wire part 33, and the D-direction first winding wire part 34. The number of turns included in each of the A-direction first winding wire part 31, the B-direction first winding wire part 32, the C-direction first winding wire part 33, and the D-direction first winding wire part 34 may be the same. In addition, from the relationship in which the A-direction first winding wire part 31 and the winding wire electrode pad 19 are connected, the number of turns of the A-direction first winding wire part 31 may be less than the numbers of turns of the B-direction first winding wire part 32, the C-direction first winding wire part 33, and the D-direction first winding wire part 34 by, for example, one or two or more.

Similarly, the lengths of the A-direction second winding wire part 71, the B-direction second winding wire part 72, the C-direction second winding wire part 73, and the D-direction second winding wire part 74 may correspond. The corresponding length is described above. The number of turns included in each of the A-direction second winding wire part 71, the B-direction second winding wire part 72, the C-direction second winding wire part 73, and the D-direction second winding wire part 74 may be the same. In addition, from the relationship in which the A-direction second winding wire part 71 and the return wire electrode pad 59 are connected, the number of turns of the A-direction second winding wire part 71 may be less than the numbers of turns of the B-direction second winding wire part 72, the C-direction second winding wire part 73, and the D-direction second winding wire part 74 by, for example, one or two or more.

In the above aspect, the description has been given using the "straight part" as the line part. That is, although the description is made using an aspect in which the first straight parts 11 and 51 are used as an example of a first line part, the second straight parts 12 and 52 are used as an example of a second line part, the third straight parts 13 and 53 are used as an example of a third line part, the fourth straight parts 14 and 54 are used as an example of a fourth line part, the fifth straight parts 15 and 55 are used as an example of a fifth line part, and the sixth straight parts 16 and 56 are used as an example of a sixth line part, but the present invention is not limited to this. Each line part may be a curved line, or only part of the plurality of line parts may be a straight part.

Further, in the above aspect, the longitudinal cross section has a rectangular shape by the second straight parts 12 and 52, the fourth straight parts 14 and 54, the fifth straight parts 15 and 55, and the sixth straight parts 16 and 56 (see Figs. 3 and 9). However, the present invention is not limited thereto, and the longitudinal cross section may have a triangular shape or a polygonal shape (polygon having five or more corners) having more corners.

### <<Manufacturing Method>>

Next, an example of a method for manufacturing the semiconductor device 100 according to the present embodiment will be described.

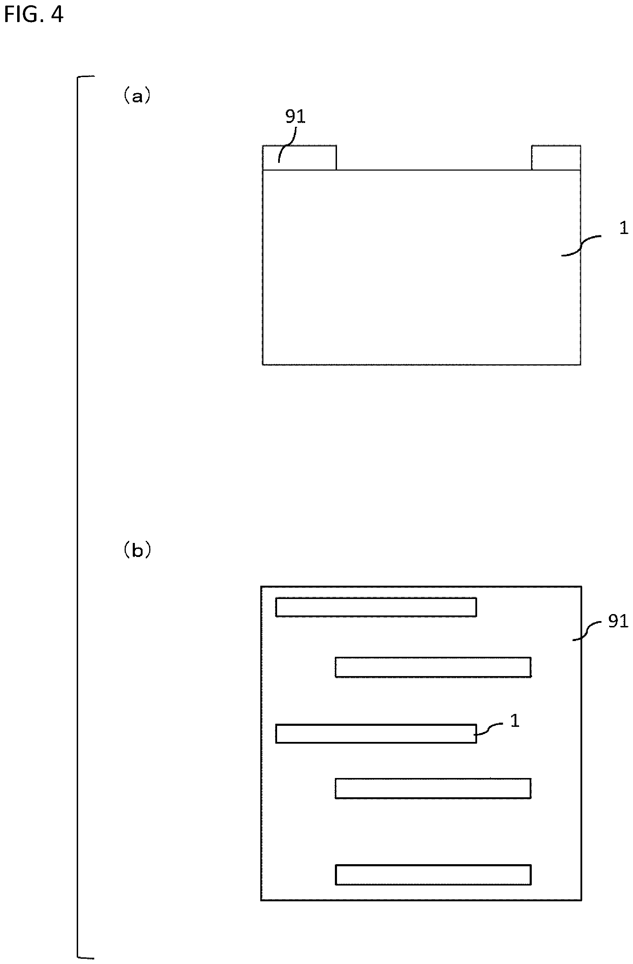

A first insulating film 91 made of an oxide film or the like is formed on the upper surface of the semiconductor layer 1 such as a wafer with a thermal oxide film or chemical vapor deposition (CVD) (see Fig. 4). Note that the first insulating film 91 also includes a resist film.

Next, a region for forming a trench is patterned by photolithography, and thereafter, the first insulating film 91 is dry etched (see Fig. 4).

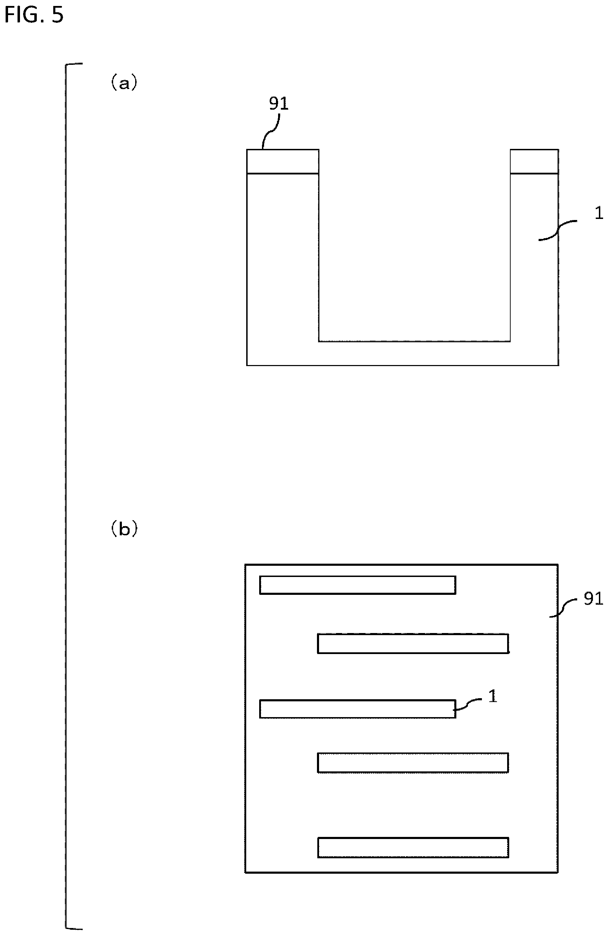

Then, the semiconductor layer 1 is dry etched using the first insulating film 91 as a mask (see Fig. 5). The damaged layer on the etched side wall may be removed by chemical dry etching (CDE), sacrificial oxide film, H₂ annealing, or the like.

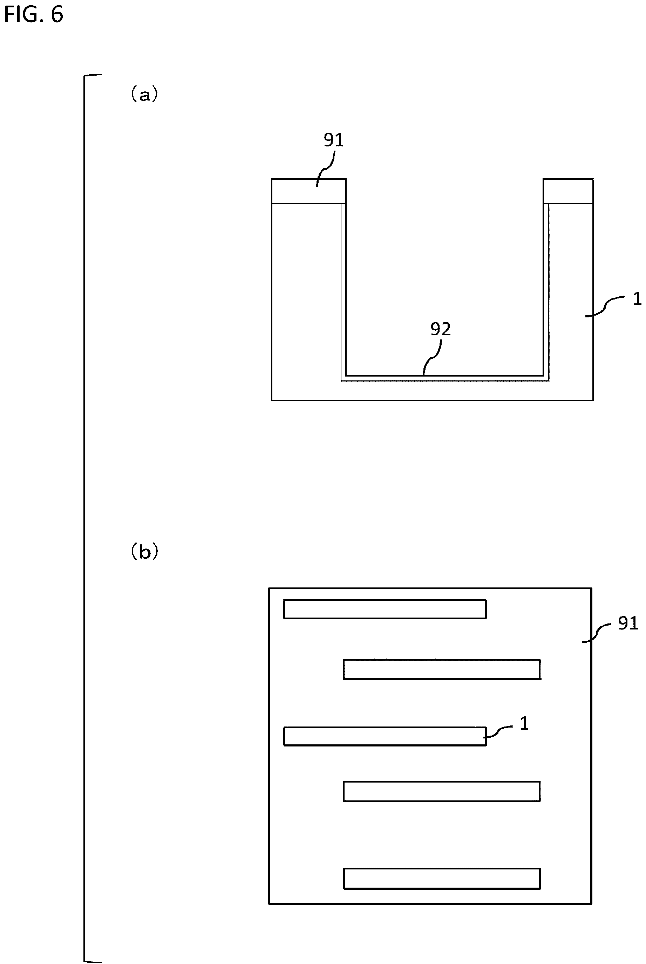

Next, a second insulating film 92 such as a thermal oxide film or a CVD oxide film is formed on the inner sidewall and the inner bottom surface of the trench (see Fig. 6). When the first insulating film 91 is composed of, for example, a resist film, the first insulating film 91 may be removed before the second insulating film 92 is formed, and then the second insulating film 92 may be formed, unlike this aspect.

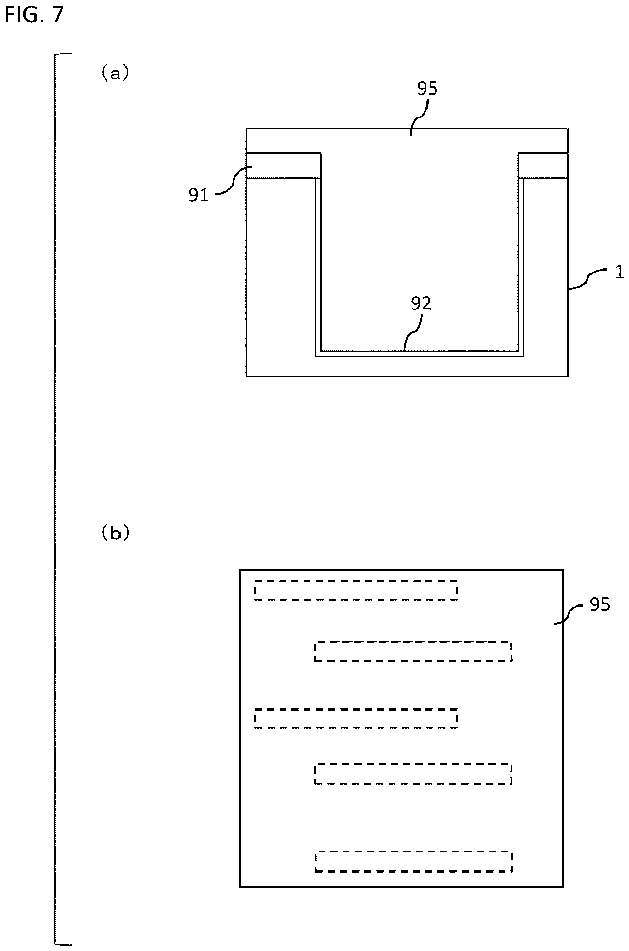

Then, the inside of the trench is filled with a conductive material 95 such as polysilicon, and the conductive material 95 such as polysilicon is also stacked on the upper surface of the first insulating film 91 (see Fig. 7). With this process, the conductive material 95 is provided inside the trench in which the second insulating film 92 is formed and on the first insulating film 91. In this case, the thickness of the conductive material 95 stacked on the first insulating film 91 may be, for example, about 0.5 µm to 2 µm.

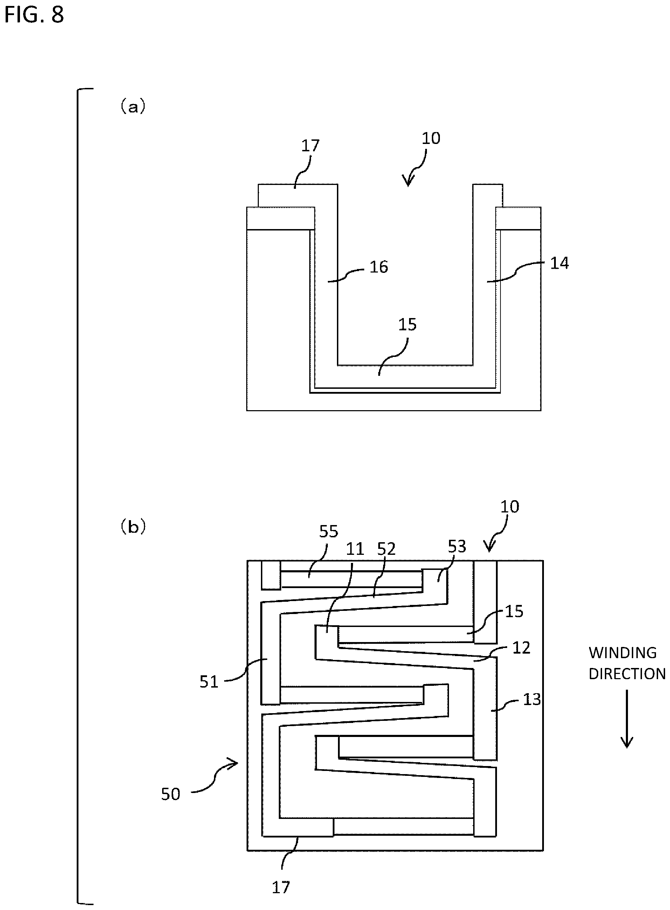

Next, patterning for forming the first winding wire part 10 and the second winding wire part 50 is performed by photolithography (see Fig. 8). In this process, the thickness of the conductive material 95 remaining on the inner bottom surface and the inner side surface of the trench may be the same as the thickness of the conductive material 95 stacked on the first insulating film 91, and may be, for example, about 0.5 µm to 2 µm. Due to forming the conductive materials 95 to have the same thickness as described above, the current flowing through the respective straight parts 11 to 17 and 51 to 56 can be made constant, which is advantageous in that the detection accuracy can be enhanced.

Next, the inside of the trench is embedded with an insulating material such as an oxide film, and the insulating material is also stacked on the upper surface (see Fig. 3). More specifically, the third insulating film 93 such as an oxide film is embedded by CVD or spin on glass (SOG), and the third insulating film 93 such as an interlayer insulating film is provided on the upper surface.

Next, photolithography is performed to open a contact hole in the third insulating film 93 such as an interlayer insulating film at the starting end part of the first winding wire part 10 and the terminal end part of the second winding wire part 50 formed of the conductive material 95 such as polysilicon. Thereafter, a contact hole is opened in the third insulating film 93 such as an interlayer insulating film by dry etching, and metal to be a PAD for an electrode wire or the like is formed at the portion where the contact hole is opened, so as to form the winding-wire electrode pad 19 and the return-wire electrode pad 59 (see Fig. 1).

### <<Function and Effect>>

Subsequently, an example of the function and effect according to the present embodiment configured as described above will be described. All the aspects to be described in "function and effect" can be employed in the above configuration.

When the winding wire parts 10 and 50 as in the present embodiment are used, the configuration of the winding wire parts 10 and 50 can be miniaturized by utilizing the manufacturing technology of the semiconductor device 100, and the number of turns per unit length can be increased. Therefore, a change in current (operation of the semiconductor device 100) can be detected with high accuracy. Further, since miniaturization is possible in this way, it is possible to prevent the semiconductor device 100 from increasing in size even when the first winding wire part 10 and the second winding wire part 50 are provided in the semiconductor layer 1.

Further, in the semiconductor device 100 in which the arrangement positions of the first electrode 61 and the second electrode 62 are determined as in the present embodiment, the first winding wire part 10 and the second winding wire part 50 are formed in the semiconductor layer 1, so that the first winding wire part 10 and the second winding wire part 50 can be accurately positioned for the current, flowing between the first electrode 61 and the second electrode 62, to be measured. Further, since no positional displacement occurs, there is no influence from the positional displacement. Therefore, a change in current can be measured without variation.

When the semiconductor device 100 is a switching element such as a MOSFET, the current changes when switching ON and OFF, so that it is advantageous to employ a quasi Rogowski coil as in the present embodiment.

As shown in Fig. 2, when the aspect in which the first electrode 61 is provided on the first main surface of the semiconductor layer 1 and the second electrode 62 is provided on the second main surface of the semiconductor layer 1 is used, a current flows between the first main surface and the second main surface, and the first winding wire part 10 and the second winding wire part 50 are provided so as to surround the current. Therefore, the manufacturing method as described above (see Figs. 3 to 8) can be used. Thus, the manufacturing process can be simplified, which is advantageous in that a practical manufacturing method can be established in consideration of mass production.

As shown in Fig. 3, when an aspect is employed in which the height positions of the first straight part 11, the second straight part 12, the third straight part 13, and the seventh straight part 17 of the first winding wire part 10 and the first straight part 51, the second straight part 52, and the third straight part 53 of the second winding wire part 50 are the same, this is advantageous in that the same steps can be used for these as shown in Figs. 7 and 8. That is, this is advantageous in that a forming process can be performed by stacking the conductive material 95 on the upper face of the first insulating film 91 (see Fig. 7) and etching the conductive material 95 (see Fig. 8).

Further, in the present embodiment, the second winding wire part 50 is used as a winding return wire instead of a straight winding return wire passing through a winding wire part like a general Rogowski coil. By employing such a second winding wire part 50, it is possible to prevent the manufacturing process from becoming too complicated.

In addition, since a winding can be formed by the second winding wire part 50, this is advantageous in that a change in current can be detected using the second winding wire part 50 as well as the first winding wire part 10.

In the present embodiment, as shown in Fig. 1, the first winding wire part 10 and the second winding wire part 50 may be disposed in a nested shape. For this reason, this is advantageous in that it is possible to prevent the size in the plane direction from increasing. In addition, "nested shape" means that in the plane direction, the outer peripheral end of the other of the first winding wire part 10 and the second winding wire part 50 is positioned peripherally outward of the inner peripheral end of one of the first winding wire part 10 and the second winding wire part 50.

Further, when the present embodiment is used, this is advantageous in that the first winding wire part 10 and the second winding wire part 50 can be appropriately replaced. That is, the first winding wire part 10 is located on the outer periphery and the second winding wire part 50 is located on the inner periphery by performing connection as shown in Fig. 9. When the resistor unit 110 is connected to the winding return wire electrode pad 59 of Fig. 9, and the non-inverting input terminal of the operational amplifier 130 of Fig. 9 is connected to the winding wire electrode pad 19, the functions of the first winding wire part 10 and the second winding wire part 50 can be reversed (see the second embodiment described later). This is advantageous in that the functions of the first winding wire part 10 and the second winding wire part 50 can be changed according to the situation.

Further, the thickness of the first winding wire part 10 and the thickness of the second winding wire part 50 may be substantially the same value. That is, the fourth straight part 14 and the sixth straight part 16 of the first winding wire part 10, and the fourth straight part 54 and the sixth straight part 56 of the first winding wire part 10 have substantially the same length. When such an aspect is used, this is advantageous in that the first winding wire part 10 and the second winding wire part 50 can be formed by a similar method. In the present application, "substantially the same" means the difference between the average value Da of the thicknesses (length in the first direction) of the first winding wire part 10 and the second winding wire part 50, and the average value D1 of the thickness of the first winding wire part 10 and the average value D2 of the thickness of the second winding wire part 50 is within 5%, that is, 0.95 × Da ≤ D1, D2 ≤ 1.05 × Da.

### Second embodiment

Next, a second embodiment of the present invention will be described.

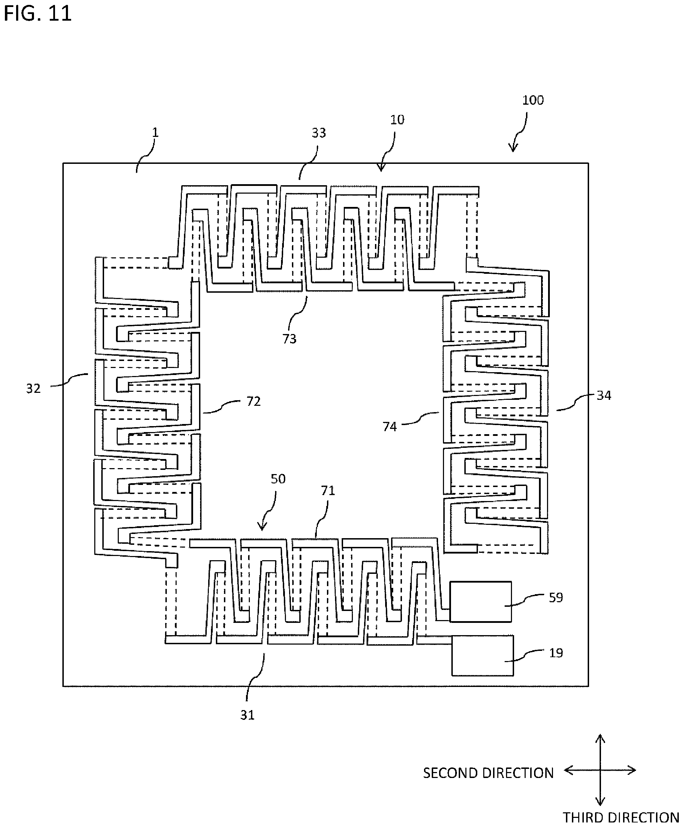

In the first embodiment, an aspect is used in which the second winding wire part 50 is provided outward of the periphery of the first winding wire part 10, but in the present embodiment, an aspect is used in which the second winding wire part 50 is provided inward of the periphery of the first winding wire part 10 as shown in Fig. 11. Others are the same as in the first embodiment. Any configuration used in each of the above embodiments can also be used in this embodiment. The members described in the above embodiments will be described with the same reference numerals.

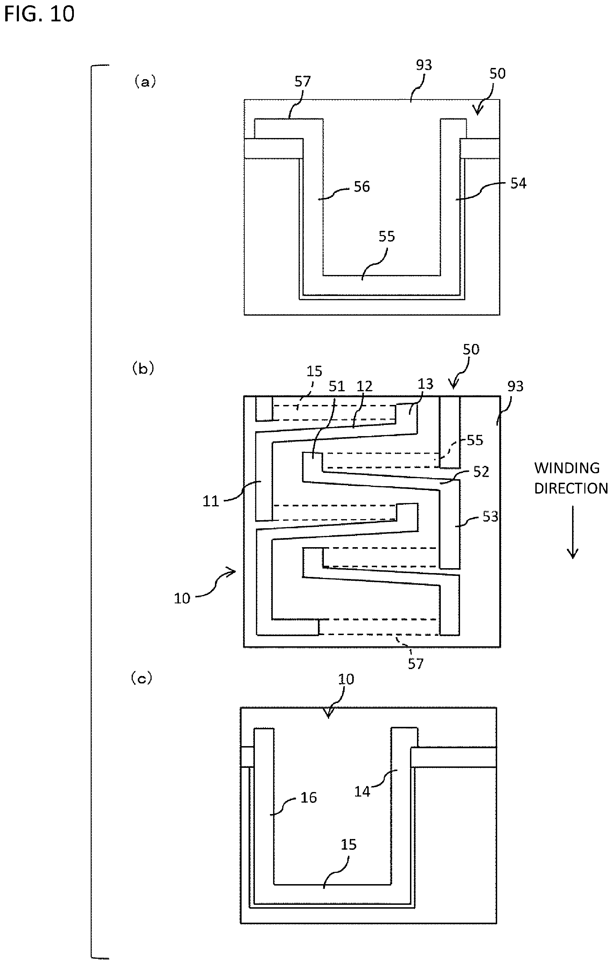

In the present embodiment, unlike the first embodiment, the first winding wire part 10 may have the first straight part 11 extending in the direction opposite to the winding direction, the second straight part 12 extending toward the peripherally inward (right side in Fig. 10) from the end of the first straight part 11 and extending in the plane direction (a direction including the second direction and the third direction) toward the direction opposite to the winding direction, the third straight part 13 extending in the direction opposite to the winding direction from the end of the second straight part 12, the fourth straight part 14 extending from one side toward the other side from the end of the third straight part 13, the fifth straight part 15 extending toward the peripherally outward (left side in Fig. 10) from the end of the fourth straight part 14 and extending in the plane direction toward the direction perpendicular to the winding direction, and the sixth straight part 16 extending from the other side toward one side from the end of the fifth straight part 15 (third aspect).

Further, the second winding wire part 50 may have the first straight part 51 extending in the winding direction, the second straight part 52 extending toward the peripherally inward (right side in Fig. 10) from the end of the first straight part 51 and extending in the plane direction (a direction including the second direction and the third direction) toward the winding direction, the third straight part 53 extending in the winding direction from the end of the second straight part 52, the fourth straight part 54 extending from one side toward the other side from the end of the third straight part 53, the fifth straight part 55 extending toward the peripherally outward(left side in Fig. 10) from the end of the fourth straight part 54 and extending in the plane direction toward the direction perpendicular to the winding direction, and the sixth straight part 56 extending from the other side toward one side from the end of the fifth straight part 55 (third aspect). Further, at the starting end part of the second winding wire part 50, a seventh straight part 57 extending in the plane direction toward the peripherally outward from the end of the sixth straight part 56 may be provided, and the end of the seventh straight part 57 and the terminal end part of the first winding wire part 10 may be connected.

Unlike this aspect, the first winding wire part 10 may have the first straight part 11 extending in the direction opposite to the winding direction, the second straight part 12 extending toward the peripherally inward from the end of the first straight part 11 and extending in the plane direction (a direction including the second direction and the third direction) toward the direction opposite to the winding direction, the third straight part 13 extending in the direction opposite to the winding direction from the end of the second straight part 12, the fourth straight part 14 extending from the other side toward one side from the end of the third straight part 13, the fifth straight part 15 extending toward the peripherally outward from the end of the fourth straight part 14 and extending in the plane direction toward the direction perpendicular to the winding direction, and the sixth straight part 16 extending from one side toward the other side from the end of the fifth straight part 15 (fourth aspect).

Further, the second winding wire part 50 may have the first straight part 51 extending in the winding direction, the second straight part 52 extending toward the peripherally inward from the end of the first straight part 51 and extending in the plane direction (a direction including the second direction and the third direction) toward the winding direction, the third straight part 53 extending in the winding direction from the end of the second straight part 52, the fourth straight part 54 extending from the other side toward one side from the end of the third straight part 53, the fifth straight part 55 extending toward the peripherally outward from the end of the fourth straight part 54 and extending in the plane direction toward the direction perpendicular to the winding direction, and the sixth straight part 56 extending from one side toward the other side from the end of the fifth straight part 55 (fourth aspect).

Considering use of the manufacturing method used in the first embodiment, by using the third aspect described firstly instead of the fourth aspect described secondly, the first straight part 11, the second straight part 12, the third straight part 13, and the seventh straight part 17 of the first winding wire part 10, and the first straight part 51, the second straight part 52, and the third straight part 53 of the second winding wire part 50 can be positioned on one side, and as a result, this is advantageous in that the manufacturing process can be simplified.

### Third embodiment

Next, a third embodiment of the present invention will be described.

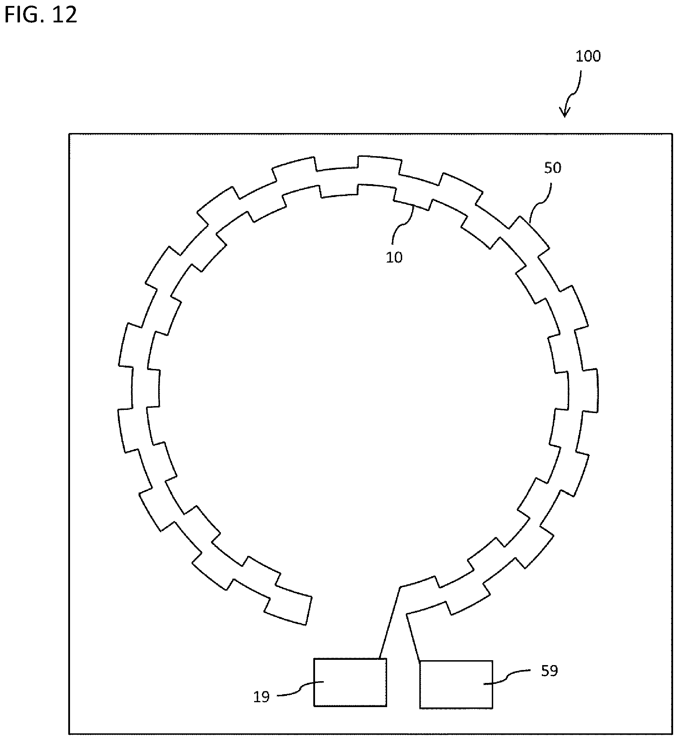

In each of the above embodiments, an aspect is used in which the direction winding wire parts 31 to 34 and 71 to 74 of the first winding wire part 10 and the second winding wire part 50 are straight, but the present invention is not limited to this. As an example, as shown in Fig. 12, each of the first winding wire part 10 and the second winding wire part 50 may have a circular shape in plan view (a plane including the second direction and the third direction). Further, each of the first winding wire part 10 and the second winding wire part 50 may have a triangular shape in plan view. Otherwise, any configuration used in each of the above embodiments can be used in this embodiment. The members described in the above embodiments will be described with the same reference numerals.

When the aspect as shown in Fig. 12 is used, it can be expected that the current flowing between the first electrode 61 and the second electrode 62 can be detected in a well-balanced manner. In addition, considering the easiness of the manufacturing process, an aspect is advantageous in which as in the first embodiment or the second embodiment, straight winding wire parts such as the A-direction first winding wire part 31, the B-direction first winding wire part 32, the C-direction first winding wire part 33 and the D-direction first winding wire part 34, and the A-direction second winding wire part 71, the B-direction second winding wire part 72, the C-direction second winding wire part 73, and the D-direction second winding wire part 74 are connected.

Each of the above embodiments has an aspect in which the first winding wire part 10 and the second winding wire part 50 are nested, so that it is possible to suppress an increase in the size in the plane direction, but the present invention is not limited to this. As shown in Fig. 12, the first winding wire part 10 and the second winding wire part 50 may not be nested.

### Fourth embodiment

Next, a fourth embodiment of the present invention will be described.

Although each of the above embodiments has an aspect in which one quasi Rogowski coil or one Rogowski coil is provided, in the fifth embodiment, a plurality of quasi Rogowski coils is provided. Otherwise, any configuration used in each of the above embodiments can be used in this embodiment. The members described in the above embodiments will be described with the same reference numerals.

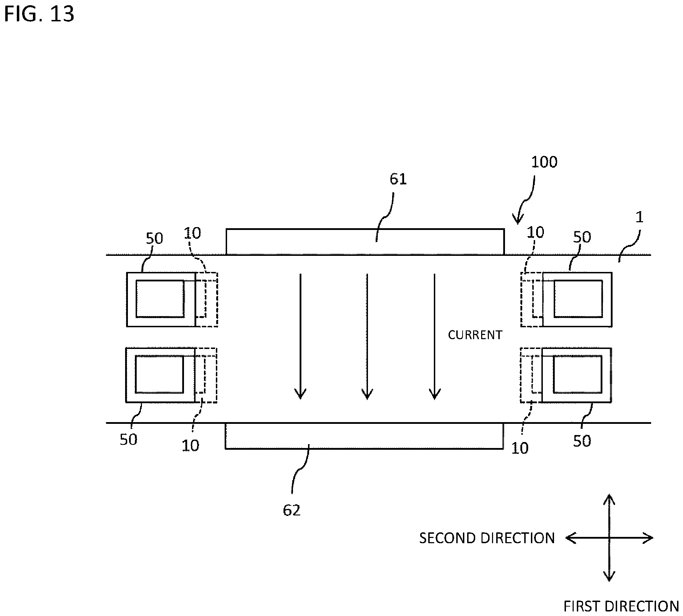

As shown in Fig. 13, the quasi Rogowski coils may be disposed in alignment in the first direction. More specifically, a detection unit including the first winding wire part 10 and the second winding wire part 50 may be provided side by side in the first direction. When this aspect is used, a change in current can be detected at two or more locations in the first direction, this is advantageous in that a change in current can be detected more accurately. However, in this aspect, since the first winding wire part 10 and the second winding wire part 50 need to be disposed so as to be stacked in the first direction, it should be noted that the manufacturing process is more complicated than that in the first embodiment.

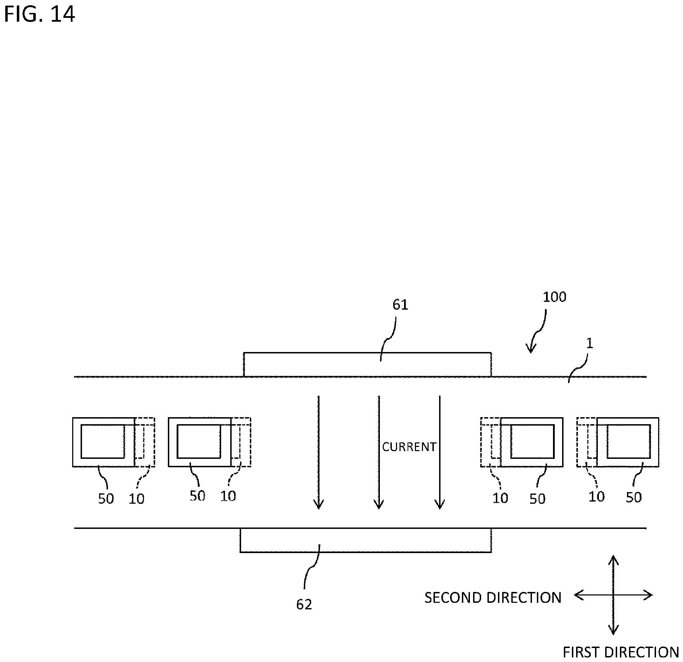

As shown in Fig. 14, another quasi Rogowski coil may be disposed on the outer peripheral side of the quasi Rogowski coil. More specifically, the detection units including the first winding wire part 10 and the second winding wire part 50 may be provided side by side in the second direction or the third direction. This aspect is also advantageous in that a change in current can be detected more accurately. This aspect is also advantageous in that the same manufacturing steps as in the first embodiment can be employed.

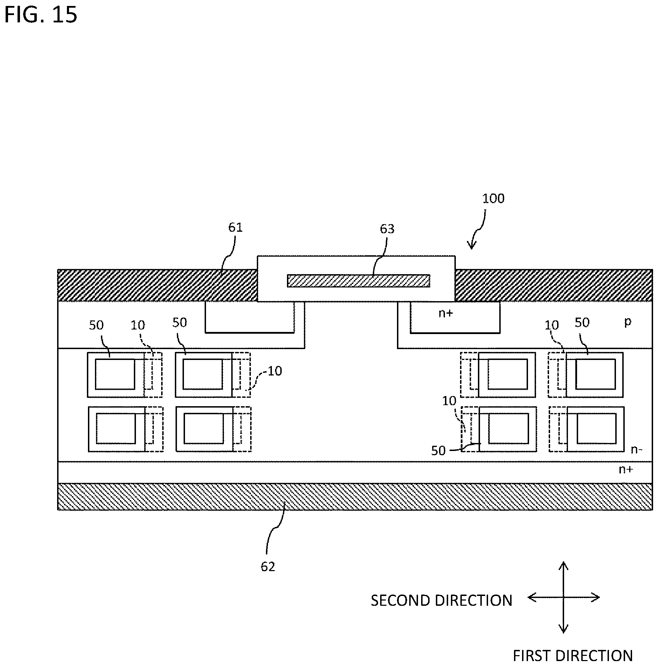

These aspects may be combined, and as shown in Fig. 15, a quasi Rogowski coil is stacked in the first direction, and another quasi Rogowski coil is provided on the outer peripheral side of the quasi Rogowski coil. More specifically, the detection units including the first winding wire part 10 and the second winding wire part 50 are provided side by side in the second direction or the third direction, and may be provided side by side in the first direction.

### Fifth embodiment

Next, a fifth embodiment of the present invention will be described.

Although each of the above embodiments has an aspect in which the first winding wire part 10, the second winding return wire part 50, and the like were provided in the semiconductor device 100, in the present embodiment, an aspect is used in which the first winding wire part 10, the second winding return wire part 50, and the like are provided in the semiconductor component 150 different from the semiconductor device 100. Other configurations are the same as those in the above-described embodiments, and any configuration used in the above-described embodiments can be used in the present embodiment.

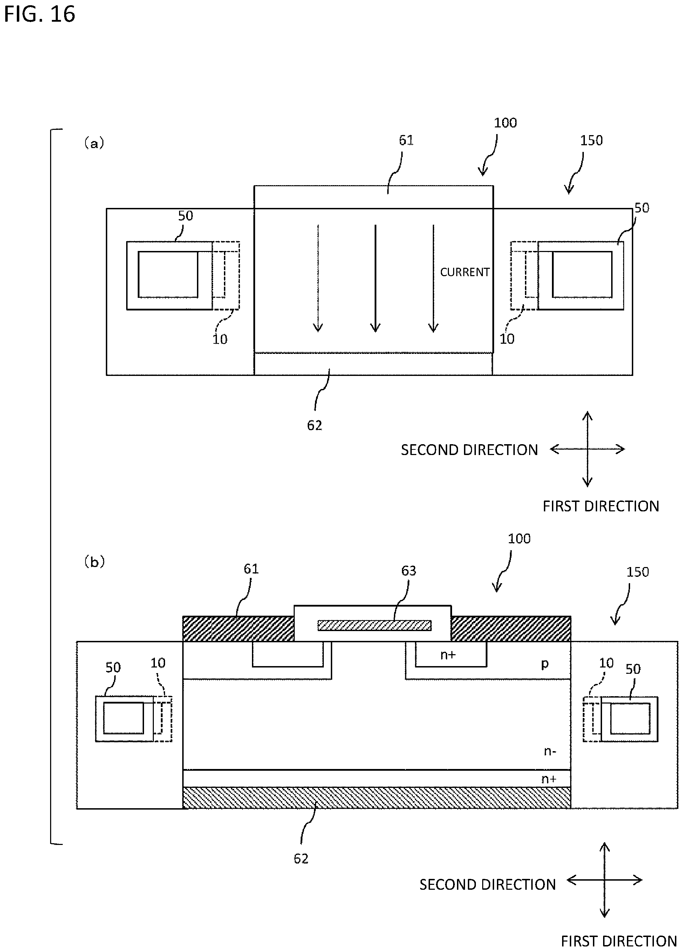

For example, the semiconductor component 150 according to the present embodiment may be arranged so as to surround the periphery of the semiconductor device 100 to be measured as shown in Fig. 16. The present embodiment is not limited thereto, and the semiconductor component 150 according to the present embodiment may be provided so as to surround a detection target through which at least a portion of the current flowing in the semiconductor device 100 flows. When the aspect described above is employed, a current flowing through the semiconductor device 100 can be indirectly measured, even if it is difficult to directly measure the current flowing through the semiconductor device 100 due to the positional relationship or the like, and thus, this aspect is advantageous in this point.

Further, use of the semiconductor component 150 as in the present embodiment is also advantageous in that a change in current can be measured even for the existing semiconductor device 100.

The foregoing descriptions of the embodiments and the disclosure of the drawings are merely one example for describing the present invention recited in the claims. The present invention recited in the claims shall not be limited by the foregoing descriptions of the embodiments and the disclosure of the drawings. Further, the recitations of the claims at the time of the filing of the present application are merely an example, and the recitations of the claims can be changed as appropriate based on the description of the specification, the drawings, and the like.

### Explanation of Reference

- 1: semiconductor layer
- 10: first winding wire part
- 50: second winding wire part
- 61: first electrode
- 62: second electrode
- 91: first insulating film
- 92: second insulating film
- 93: third insulating film
- 100: semiconductor device
- 150: semiconductor component

## Claims

1. A semiconductor device comprising:
a first electrode;
a second electrode; and
a semiconductor layer including a first winding wire part provided so as to surround a current flowing between the first electrode and the second electrode, and a second winding wire part connected to a terminal end part of the first winding wire part and returning from the terminal end part toward a starting end part side of the first winding wire part.

2. The semiconductor device according to claim 1,
wherein the second winding wire part is disposed outward of a periphery of the first winding wire part, or the first winding wire part is disposed outward of a periphery of the second winding wire part.

3. The semiconductor device according to claim 2, wherein
the first winding wire part and the second winding wire part are disposed in a nested shape.

4. The semiconductor device according to any one of claims 1 to 3, wherein
thickness of the first winding wire part and thickness of the second winding wire part are substantially a same value.

5. A semiconductor component comprising a semiconductor layer, wherein
the semiconductor layer includes
a first winding wire part, and
a second winding wire part connected to a terminal end part of the first winding wire part and returning from the terminal end part toward a starting end part side of the first winding wire part, and
the semiconductor component is disposed so as to surround a current flowing in an object to be measured.

6. A method of manufacturing a semiconductor device, comprising steps of:
forming a first insulating film partially on a semiconductor layer;
forming a trench using the first insulating film;
forming a second insulating film on an inner side wall and an inner bottom surface of the trench;
providing a conductive material in the trench where the second insulating film is formed and on the first insulating film;
forming a first winding wire part and a second winding wire part by patterning the conductive material; and
covering the winding wire part and the winding return wire part with a third insulating film, wherein
the second winding wire part is connected to a terminal end part of the first winding wire part, and returns from the terminal end part toward a starting end part side of the first winding wire part.
